# EUROPÄISCHE PATENTSCHRIFT

(11) **EP 0 361 320 B1**
(45) Veröffentlichungstag und Bekanntmachung des Hinweises auf die Patenterteilung: **01.12.1993**
(21) Anmeldenummer: 89117502.8
(22) Anmeldetag: 21.09.1989
(51) Int. Cl.: H01L 29/167

(54) **Leistungshalbleiterdiode**
Power semiconducter diode
Diode de puissance semi-conductrice

(30) Priorität: 27.09.1988 DE 3832748
(43) Veröffentlichungstag der Anmeldung: 04.04.1990
(73) Patentinhaber: Asea Brown Boveri Aktiengesellschaft, 68309 Mannheim (DE)
(72) Erfinder: Kelberlau, Ulrich, Dr., D-6840 Lampertheim (DE); Kmitta, Hubertus, D-6944 Hemsbach (DE); Leifels, Joachim, D-6800 Mannheim (DE)
(74) Vertreter: Rupprecht, Klaus, Dipl.-Ing.

(56) Entgegenhaltungen:
- EP-A- 0 071 276
- DE-A- 3 231 676
- US-A- 3 860 947
- PATENT ABSTRACTS OF JAPAN, vol. 8, no. 78 (E-237)[1515], 10th April 1984;& JP-A-58 223 375

## Beschreibung

Die Erfindung bezieht sich auf eine Leistungshalbleiterdiode, die schnell schaltet, eine hohe Sperrspannung aufweist und mit einem planaren Randabschluß.

Solche schnellschaltenden Dioden werden beispielsweise zur Beschaltung von schnell abschaltenden Leistungshalbleiterbauelementen, wie z.B. Leistungstransistoren verwendet. Mit dieser Anwendung sind bestimmte Anforderungen an die Dioden verbunden. Insbesondere wird eine Abschaltzeit von typisch 40ns bis zum Erreichen der Rückstromspitze und ein danach allmähliches Abklingen des Rückstromes (soft recovery) gefordert. Außerdem soll beim schnellen Einschalten der Diode eine möglichst geringe Überhöhung der Flußspannung auftreten. Dioden, die diesen Anforderungen genügen, werden nach unterschiedlichen Techniken, beispielsweise als epitaktische Dioden oder als doppeltdiffundierte Dioden, d.h. sowohl mit einer Bor- als auch einer Phosphor- oder Arsen-Diffusion, hergestellt.

Um die genannten Schalteigenschaften zu erreichen, sind bestimmte Maßnahmen zur Gestaltung der Dioden notwendig oder üblich, die die allgemein bekannten Probleme beim Randabschluß verstärken und zu aufwendigen Randgestaltungen führen, wobei die erzielte Sperrspannung meistens trotz aufwendiger Herstellung deutlich unter der theoretisch möglichen Volumenabbruchspannung liegt.

Übliche Maßnahmen zur Einstellung der gewünschten Schalteigenschaften sind die Einstellung einer kleinen Trägerlebensdauer mit einer darausfolgenden Notwendigkeit einer möglichst geringen Dicke der schwachdotierten n-leitenden Zone.

Verschiedene Möglichkeiten zur Gestaltung des Randabschlusses sind beschrieben bei Ghandhi, J.K., Semiconductor Power Devices Verlag Wiley and Sons, New York, 1977, Kapitel 2. Zu diesen bekannten und üblichen Ausführungsarten des Randabschlusses gehören Passivierungsgräben, die nach der sogenannten Moat-Technik ausgeführt werden, und die planare Passivierung in Verbindung mit Feldplatten oder Feldringen, die auch Guard-Ringe genannt werden.

Die Moat-Technik erfordert eine Tiefätzung, die technologisch aufwendig ist; die anschließende Glaspassivierung und die dazu notwendige Photomaskentechnik auf tiefenstrukturierten Oberflächen ist ebenfalls aufwendig und schwierig. Außerdem erreicht man entweder mit dieser Art des Randabschlusses nicht 100% der theoretisch möglichen Volumendurchbruchspannung, oder die Oberflächenfeldstärken am pn-Übergang werden extrem hoch und sind schwierig zu passivieren. Zudem reduzieren möglicherweise vorhandene positive Ladungen im Passivierungsglas die Höhe der erreichbaren Sperrspannung.

Die Nachteile hinsichtlich der Spannungshöhe und der Empfindlichkeit gegenüber Ladungen gelten prinzipiell auch bei der planaren Passivierung. Technologische Schwierigkeiten ergeben sich hier aus den hohen Anforderungen an die Maßhaltigkeit des Photomaskenprozesses zur Strukturierung der Guard-Ringe, deren Abstände sehr klein sind und nur geringe Toleranzen aufweisen dürfen. Zudem bereitet die Dimensionierung der Ringabstände bei Dioden, deren Trägerlebensdauereinstellung mit Gold erfolgt, Schwierigkeiten, weil Gold den spezifischen Widerstand von Silizium in nicht genau vorhersehbarer Weise ändert und die Ringabstände auf den spezifischen Widerstand angepaßt werden müssen, um sie hinsichltich ihrer Wirkung zu optimieren.

Eine gattungsgemäße Diode ist aus JP-A-58 223 375 bekannt.

In der Druckschrift EP-A-00 71 276 ist eine Diode beschrieben, bei der eine hohe Sperrspannung durch Wahl eines Ausgangsmaterials mit hohem spezifischem Widerstand angestrebt wird. Um eine schnelle Diode mit kleinem Sperrstrom zu erzielen, wird eine Golddiffusion vorgeschlagen mit einer definierten inhomogenen Goldverteilung.

Der DE-A-32 31 676 ist eine PIN-Diode zu entnehmen, bei der u. a. auch Gold als Ladungsträgerkiller verwendet werden kann. Der Ladungsträgerkiller darf dort nur einen geringfügigen Ladungsträgerkompensationseffekt aufweisen.

Der Erfindung liegt die Aufgabe zugrunde, eine Ausführung einer Diode der eingangs beschriebenen Art anzugeben, mit der die dargestellten technologischen Nachteile vermieden werden, wodurch die Diode einfach herzustellen ist, und bei der die Sperrspannung praktisch nicht durch den Randabschluß begrenzt ist.

Diese Aufgabe wird gelöst durch eine Leistungshalbleiterdiode, die schnell schaltet und deren Sperrspannung der Volumendurchbruchsspannung entspricht, mit
- einer ersten Hauptfläche, an die eine hochdotierte, n-leitende Schicht grenzt,
- einer zweiten Hauptfläche, an die eine niedrigdotierte n-leitende Schicht grenzt, die sich auf der hochdotierten n-leitenden Schicht befindet,
- einer von der zweiten Hauptfläche her in die niedrigdotierte n-leitende Schicht lateral strukturiert eindiffundierte p⁺-leitende Schicht,
- einer die p⁺-leitende Schicht in einem Abstand davon umschließenden, ebenfalls in die niedrigdotierte n-leitende Schicht eindiffundierte n⁺-Schicht, die eine Ausdehnung der Raumladungszone in lateraler Richtung bis zum Diodenrand verhindert,
- einem pn-Übergang zwischen der niedrigdotierten n-leitenden Schicht und der p⁺-leitenden Schicht,
- einem planaren Randabschluß, der gebildet ist durch eine Passivierungsschicht auf der zweiten Hauptfläche, die den pn-Übergang sowie die niedrigdotierte n-leitende Schicht und die n⁺-leitende Schicht abdeckt und
- einer Kontaktmetallisierung auf der p⁺-leitenden und der hochdotierten n-leitenden Schicht,
wobei
- in einem oberflächennahen Bereich, dessen Dicke mindestens 20% der Dicke der an die zweite Hauptfläche grenzenden niedrigdortierten n-leitenden Schicht beträgt, die Dotierungskonzentration vollständig mit Hilfe einer Golddiffusion kompensiert ist.

Der Erfindung liegt der allgemeine Lösungsgedanke zugrunde,ein Dotierungsprofil entsprechend der weiter unten erläuterten Figur 2b vorzusehen, also einen axialen Verlauf der effektiven Dotierungskonezentration, der zu einer lateralen Dehnung der Raumladungszone führt, und wobei eine Feldstärkenüberhöhung am Rand der p⁺-Zone vermieden wird.

Das angestrebte Dotierungsprofil wird mit einer Golddotierung der n⁻-Schicht erreicht.

Die erfindungsgemäße Lösung hat den Vorteil, daß die Diode eine Sperrspannung aufweist, die der Volumendurchbruchsspannung entspricht, ohne den Nachteil des schlechten Einschaltverhaltens in Kauf nehmen zu müssen, der bei einer homogen hochohmig ausgeführten n⁻-Schicht gegeben wäre. Außerdem kann die Diode auf einfache Weise hergestellt werden, da keine hohen Anforderungen an die Genauigkeit der Diffusionsmaske für das p⁺-Gebiet gestellt werden. Es sind weder Guard-Ringe erforderlich, noch ein Passivierungsgraben. Es muß lediglich der Bereich zwischen der Austrittsstelle des pn-Übergangs an die Oberfläche und der die laterale Ausdehnung der Raumladungszone begrenzenden n⁺-Schicht sicher mit einer Passivierungsschicht abgedeckt werden.

Eine nähere Erläuterung erfolgt anhand der Zeichnung.

Es zeigt:
- Figur 1: eine planarpassivierte Diode,
- Figur 2a: den Verlauf der Dotierungskonzentration der in Figur 1 dargestellten Diode vor Durchführung einer Golddiffusion zur Kompensation der Dotierungskonzentration in einem oberflächennahen Bereich, und
- Figur 2b: den Verlauf der Dotierungskonzentration nach Durchführung der Golddiffusion.

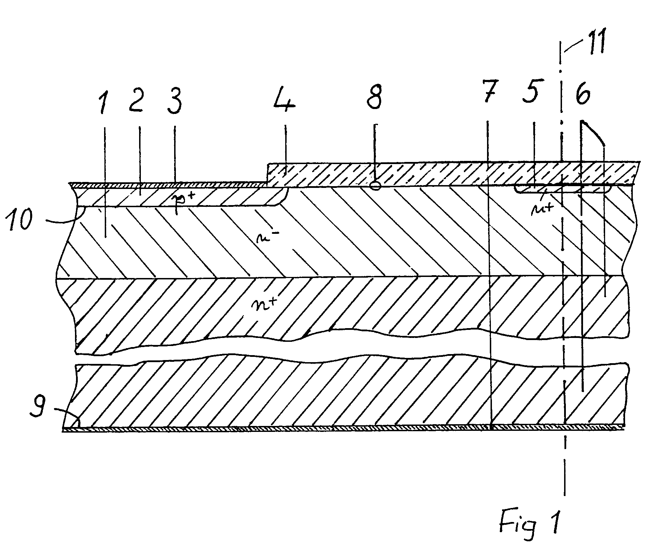

Figur 1 zeigt in schematischer Darstellung einen Querschnitt durch den Randbereich einer Silizium-Leistungshalbleiterdiode in einem Herstellungsschritt vor dem Zerteilen des Wafers. Die Diode ist aufgebaut auf einem Substrat, das als hochdotierte n-leitende Schicht 6 dargestellt ist, und deren Oberfläche als erste Hauptfläche 9 bezeichnet ist. Auf der hochdotierten n-leitenden Schicht 6 befindet sich eine beispielsweise darauf epitaktisch abgeschiedene niedrigdotierte n-leitende Schicht 1, die die zweite Hauptfläche 8 der Diode bildet. Von der zweiten Hauptfläche 8 her ist in die niedrigdotierte n-leitende Schicht 1 in einem mittleren Bereich eine p⁺-leitende Schicht 2 eindiffundiert. Die p⁺-leitende Schicht 2 bildet mit der niedrigdotierten n-leitenden Schicht 1 einen pn-Übergang 10. Die Austrittsstelle des pn-Übergangs 10 an die zweite Oberfläche 8 ist planar mit einer Passivierungsschicht 4 abgedeckt, die beispielsweise aus Passivierungsglas bestehen kann. Die Passivierungsschicht 4 überdeckt auf der Oberfläche 8 den gesamten Randbereich der Diode, also den an die Oberfläche 8 grenzenden Teil der niedrigdotierten n-leitenden Schicht 1 und eine im äußersten Rand der Diode von der Oberfläche 8 her diffundierte n⁺-Schicht 5. Eine gestrichelte Linie 11 zeigt an, an welcher Stelle ein Silizium-wafer getrennt wird um mehrere gleichzeitig hergestellte Dioden auf einem Wafer in Einzel-Diodenchips zu trennen. Auf die erste Oberfläche 9 ist in üblicher Weise eine kathodenseitige Kontaktmetallisierung 7 aufgebracht und auf der p⁺-Schicht 2 eine anodenseitige Kontaktmetallisierung 3.

Solche in Figur 1 dargestellten planare Dioden ohne Feldringe sind dem Fachmann zwar an sich bekannt, jedoch handelt es sich dabei insofern nicht um gattungsgemäße Dioden, als diese nicht eine Sperrspannung aufweisen, die der Volumendurchbruchsspannung entspricht. Im Hinblick auf das geforderte Einschaltverhalten sind nämlich solche Dioden in der niedrigdotierten n-leitenden Schicht niederohmig dimensioniert, wodurch an dem mit kleinem Radius gekrümmten Rand der bei schnellen Dioden typisch dünnen p⁺-Schicht eine starke Feldstärkeüberhöhung auftritt, die das Erreichen der maximal möglichen Sperrspannung verhindert.

Diffundiert man in die Diode Gold zur Trägerlebensdauereinstellung, so stellt man fest, daß die Gold-Rekombinationszentren axial nicht homogen verteilt sind, sondern daß ihre Konzentration zur p⁺-dotierten Oberfläche 8 hin ansteigt, wie in Figur 2b zu erkennen ist. Die Stärke dieses Effekts läßt sich steuern durch Variation der Bor-Diffusion zur Herstellung der p⁺-Schicht.

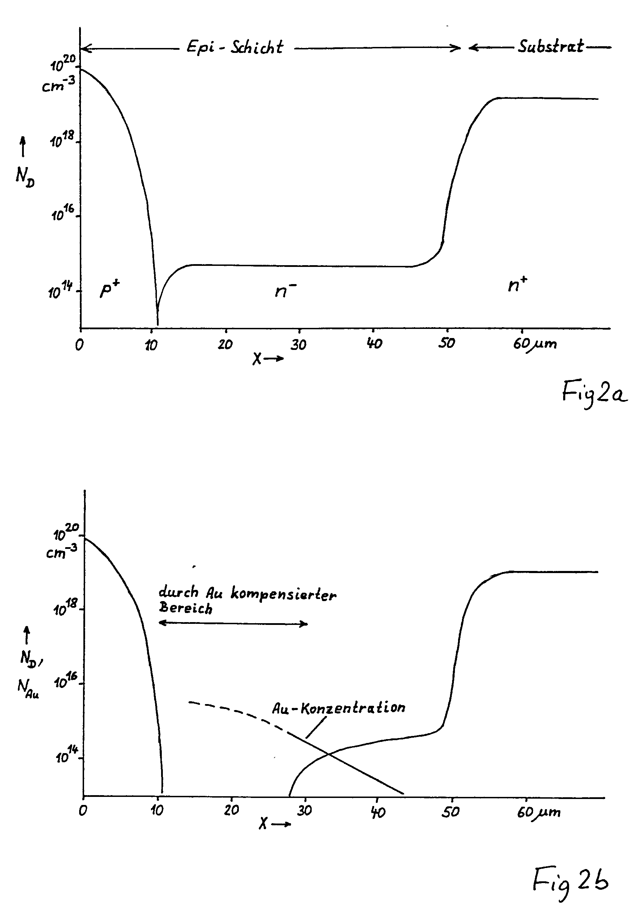

Gold hat in Silizium allgemein die Eigenschaft ein donator- und ein Akzeptorniveau zu bilden. Das hat zur Folge, daß im n-leitenden Silizium Elektronen von dem Akzeptorniveau eingefangen werden, so daß die Grunddotierung kompensiert wird. Es ist nicht von vornherein selbstverständlich, daß durch Kompensation mit Gold hochohmig gemachtes Silizium sich bezüglich der Ausdehnung der Raumladungszone genauso verhält wie Silizium, welches aufgrund einer niedrigen Grunddotierung hochohmig ist. Es ist nämlich nicht genau bekannt, wie der Ladungszustand der Goldatome in der Raumladungszone ist. Durch Messung der effektiven Dotierungskonzentration mit einer Kapazitäts-Spannungs-Messung (CV-Methode) läßt sich nachweisen, daß diese Kompensation in der Raumladungszone tatsächlich vorhanden ist. In Figur 2b ist der axiale Verlauf der effektiven Dotierungskonzentration N_{D} einer golddotierten epitaktischen Diode dargestellt, der nach einer solchen CV-Methode ermittelt wurde. In Figur 2a ist die konstante Grunddotierung der epitaktischen Schicht mit eindiffundierter p⁺-Schicht und die Dotierung des Substrats vor der Golddiffusion dargestellt. Der davon abweichende nach der Golddiffusion gemeßene Verlauf der effektiven Dotierungskonzentration gemäß Figur 2b belegt die vorausgegangene Aussage. Entsprechend dem bereits erwähnten axialen Verlauf der Goldkonzentration ist der durch Kompensation hervorgerufene Verlauf der effektiven Dotierungskonzentration zur Oberfläche hin stark abnehmend. Der gefundene Verlauf der in der Raumladungszone wirksamen effektiven Dotierungskonzentration ist entscheidend für die Funktion der erfindungsgemäß ausgeführten Diode. Während nämlich die relativ hohe effektive Dotierungskonzentration in größerer Entfernung von der Oberfläche 8 ein Einschalten der Diode mit geringer Überhöhung der Flußspannung bewirkt, hat die starke Verringerung der n-Dotierung in Oberflächennähe zur Folge, daß sich die Raumladungszone am Rand des p⁺-Gebiets 2 in lateraler Richtung weit ausdehnt. Daraus resultiert eine entsprechend starke Absenkung der maximalen Feldstärke an dieser Stelle der Raumladungszone. Eine Ausdehnung der Raumladungszone in lateraler Richtung bis an den Rand des Chips wird verhindert durch die n⁺-dotierte Schicht 5, deren Wirkung in Analogie zur axialen Stoppschicht von Leistungshalbleiterbauelementen zu sehen ist.

Während also bei üblichen planaren Dioden ohne Guard-Ringe, die wegen des Einschaltverhaltens in der n⁻-Zone niederohmig dimensioniert sind, am Rand der p⁺-Zone eine starke Feldstärkeüberhöhung das Erreichen der maximal möglichen Sperrspannung verhindert, tritt bei der erfindungsgemäßen Ausführung keine Feldstärkeüberhöhung am Rand auf. Damit kann eine Sperrspannung in Höhe der theoretisch möglichen Volumendurchbruchsspannung mit einem technologisch einfach herstellbaren Randabschluß erreicht werden, ohne den Nachteil des schlechten Einschaltverhaltens in Kauf zu nehmen, der bei entsprechend hochohmiger Ausführung der epitaktischen Schicht gegeben wäre.

Die Erfindung ist nicht nur auf epitaktische Dioden gemäß dem Ausführungsbeispiel anwendbar, sondern auch für schnelle doppeltdiffundierte Dioden aus homogen dotiertem Grundmaterial mit einem sperrenden planaren pn-Übergang, der durch Diffusion von Bor hergestellt wurde, und mit einer durch Diffusion von Phosphor oder Arsen hergestellten n⁺-Schicht auf der dem pn-Übergang gegenüberliegenden Hauptfläche.

Da der Randabschluß der erfindungsgemäßen Diode weder einen Passivierungsgraben (Moat), noch Guard-Ringe etc. enthält, sind die Anforderungen an die Genauigkeit der Diffusionsmaske zur Herstellung des p⁺-Gebiets gering. Die erzielte Genauigkeit des p⁺-Gebiets ist auch von untergeordneter Bedeutung für die Funktion des Bauelements, weil lediglich gewährleistet sein muß, daß der Bereich zwischen der Austrittsstelle des pn-Übergangs an der Oberfläche und der n⁺-Schicht 5 sicher mit der Passivierungsschicht bedeckt ist, wobei auch eine größere Überlappung zulässig ist.

## Patentansprüche

1. Leistungshalbleiterdiode, die schnell schaltet und deren Sperrspannung der Volumendurchbruchsspannung entspricht, mit
- einer ersten Hauptfläche (9), an die eine hochdotierte, n-leitende Schicht (6) grenzt,
- einer zweiten Hauptfläche (8), an die eine niedrigdotierte n-leitende Schicht (1) grenzt, die sich auf der hochdotierten n-leitenden Schicht (6) befindet,
- einer von der zweiten Hauptfläche (8) her in die niedrigdotierte n-leitende Schicht (1) lateral strukturiert eindiffundierte p⁺-leitende Schicht (2),
- einer die p⁺-leitende Schicht (2) in einem Abstand davon umschließenden, ebenfalls in die niedrigdotierte n-leitende Schicht eindiffundierte n⁺-Schicht (5), die eine Ausdehnung der Raumladungszone in lateraler Richtung bis zum Diodenrand verhindert,
- einem pn-Übergang (10) zwischen der niedrigdotierten n-leitenden Schicht (1) und der p⁺-leitenden Schicht (2),
- einem planaren Randabschluß, der gebildet ist durch eine Passivierungsschicht (4) auf der zweiten Hauptfläche (8), die den pn-Übergang (10) sowie die niedrigdotierte n-leitende Schicht (1) und die n⁺-leitende Schicht (5) abdeckt und
- einer Kontaktmetallisierung (3,7) auf der p⁺-leitenden und der hochdotierten n-leitenden Schicht (6),
dadurch gekennzeichnet, daß
- in einem oberflächennahen Bereich, dessen Dicke mindestens 20% der Dicke der an die zweite Hauptfläche (8) grenzenden niedrigdotierten n-leitenden Schicht (1) beträgt, die Dotierungskonzentration vollständig mit Hilfe einer Golddiffusion kompensiert ist.

2. Leistungshalbleiterdiode nach Anspruch 1, dadurch gekennzeichnet, daß die Diode nach einem Epitaxieverfahren hergestellt ist.

3. Leistungshalbleiterdiode nach Anspruch 1, dadurch gekennzeichnet, daß die Diode als doppeltdiffundierte Diode ausgeführt ist, wobei der sperrende planare pn-Übergang durch Diffusion von Bor hergestellt wurde und die hochdotierte n-leitende Schicht (6) durch Diffusion von Phosphor oder Arsen.

## Claims

1. Power semiconductor diode, which switches quickly and whose reverse voltage corresponds to the volume-breakdown voltage, having
- a first main surface (9) which is bounded by a highly-doped, n-conductive layer (6),
- a second main surface (8) which is bounded by a low-doped n-conductive layer (1) which is located on the highly-doped n-conductive layer (6),
- a p⁺-conductive layer (2) which is diffused from the second main surface (8) in a laterally structured manner into the low-doped n-conductive layer (1),
- an n⁺-layer (5) which encloses the p⁺-conductive layer (2) at a distance therefrom, is likewise diffused into the low-doped n-conductive layer and prevents expansion of the spatial-charge zone in the lateral direction as far as the diode edge,
- a pn-junction (10) between the low-doped n-conductive layer (1) and the p⁺-conductive layer (2),
- a planar edge closure which is formed by a passivation layer (4) on the second main surface (8), which covers the pn-junction (10) and the low-doped n-conductive layer (1) and the n⁺-conductive layer (5), and
- contact metallisation (3, 7) on the p⁺-conductive and on the highly-doped n-conductive layer (6),
characterised in that
- the doping concentration being completely compensated for with the aid of gold diffusion in a region which is close to the surface and whose thickness is at least 20% of the thickness of the low-doped n-conductive layer (1) which bounds the second main surface (8).

2. Power semiconductor diode according to Claim 1, characterised in that the diode is produced in accordance with an epitaxial method.

3. Power semiconductor diode according to Claim 1, characterised in that the diode is designed as a double-diffused diode, the blocking, planar pn-junction having been produced by diffusion of boron and the highly-doped, n-conductive layer (6) having been produced by diffusion of phosphorous or arsenic.

## Revendications

1. Diode de puissance à semi-conducteurs à commutation rapide, dont la tension de blocage correspond à la tension de claquage en volume par avalanche comportant
- une première surface principale (9) avec, contiguë à celle-ci, une couche conductrice n (6) fortement dopée,
- une deuxième surface principale (8) avec, contiguë à celle-ci, une couche conductrice n (1) faiblement dopée qui est située sur la couche conductrice n (6) fortement dopée,
- une couche conductrice p⁺ (2) structurée latéralement, diffusée dans la couche conductrice n (1) faiblement dopée à partir de la deuxième surface principale (8),
- une couche n⁺ (5) également diffusée dans la couche conductrice n faiblement dopée qui entoure la couche conductrice p⁺ (2) à une certaine distance de celle-ci et empêche la zone de charge d'espace de s'étendre latéralement jusqu'au bord de la diode,
- une transition pn (10) entre la couche conductrice n (1) faiblement dopée et la couche conductrice p⁺,
- un contournage planaire qui est formé d'une couche de passivation (4) appliquée sur la deuxième surface principale (8) qui recouvre la transition pn (10) ainsi que la couche conductrice n (1) faiblement dopée et la couche conductrice n⁺ (5) et
- une métallisation de contact (3, 7) appliquée sur la couche conductrice p⁺ et la couche conductrice n (6) fortement dopée,
caractérisée par le fait que
- dans une zone proche de la surface, dont l'épaisseur représente au moins 20 % de l'épaisseur de la couche conductrice n faiblement dopée contiguë à la deuxième surface principale (8), la concentration de dopage est intégralement compensée par une diffusion d'or.

2. Diode de puissance à semi-conducteurs selon la revendication 1, caractérisée par le fait que la diode est fabriquée selon un procédé épitaxial.

3. Diode de puissance à semi-conducteurs selon la revendication 1, caractérisée par le fait que la diode est réalisée sous forme de diode à double diffusion, la transition pn planaire de blocage étant obtenue par diffusion de bore et la couche conductrice n (6) fortement dopée étant obtenue par diffusion de phosphore ou d'arsenic.
